Europäisches Patentamt

European Patent Office

Office européen des brevets

(19)

(11) Veröffentlichungsnummer: **0 028 302**
**B1**

## (12) EUROPÄISCHE PATENTSCHRIFT

(45) Veröffentlichungstag der Patentschrift:
**09.02.83**

(51) Int. Cl.³: **G 01 R 33/022**

(21) Anmeldenummer: **80105336.4**

(22) Anmeldetag: **06.09.80**

(54) **Magnetfelddifferenzsonde.**

(30) Priorität: **24.10.79 DE 2942847**

(43) Veröffentlichungstag der Anmeldung:
**13.05.81 Patentblatt 81/19**

(45) Bekanntmachung des Hinweises auf die Patenterteilung:
**09.02.83 Patentblatt 83/6**

(84) Benannte Vertragsstaaten:
**AT CH FR GB IT LI**

(56) Entgegenhaltungen:
**BE-A-760 017**
**DE-B-1 153 451**
**US-A-3 488 579**
**US-A-3 757 209**

(73) Patentinhaber: **Förster, Friedrich, Postfach 925 In Laisen 70, D-7410 Reutlingen (DE)**

(72) Erfinder: **Förster, Friedrich, Postfach 925 In Laisen 70, D-7410 Reutlingen (DE)**

## Magnetfelddifferenzsonde

Die vorliegende Erfindung betrifft eine Magnetfelddifferenzsonde mit 2 Magnetfeldsensoren, die parallel zu einer gedachten Gerade ausgerichtete magnetische Achsen und die Ausrichtung dieser magnetischen Achsen bestimmende Magnetkernelemente besitzen, die voneinander einen bestimmten Basisabstand entlang der gedachten Geraden aufweisen, die an eine elektronische Auswerteeinrichtung angeschlossen sind und die am Ausgang der letzteren ein elektrisches Signal entstehen lassen, das gemäß dem gegebenen Basisabstand der Differenz, der an den Orten der beiden Magnetfeldsensoren vorhandenen Magnetfelder entspricht, wobei die Ausrichtung der magnetischen Achsen parallel zur gedachten Gerade erzielt wird, indem die Magnetfeldsensoren oder zumindest ihre Magnetkernelemente an einer parallel zur gedachten Geraden verlaufenden, gespannten, amagnetischen Anordnung befestigt sind, die zwischen dem die Ausrichtung der magnetischen Achsen bestimmenden Magnetkernelementen nicht gestützt ist.

Derartige Differenzsonden benutzt man vorwiegend zum Aufsuchen von im Erdboden oder im Wasser verborgenen Ferromagnetischen Körpern wie Bombenblindgängern, Minen, Schiffen, Schiffsteilen und dergleichen. Das geschieht, indem man die von diesen Körpern verursachte Störung des sonst homogenen magnetischen Erdfeldes, den Erdfeldgradienten, für die Ortung der Körper auswertet. In vielen Fällen kommen dabei Oberwellenmagnetfeldsensoren zum Einsatz, die als Wandlerorgan ein weichmagnetisches Kernelement hoher magnetischer Permeabilität besitzen. Dieses wird von einem magnetischen Wechselfeld bestimmter Frequenz bis in die Sättigung magnetisiert. Ein in die Richtung des Kernelements fallendes äußeres Magnetfeld ruft eine Unsymmetrie der Magnetisierungskennlinie des Kernelementes hervor und läßt in einer das Kernelement umgebenden Wicklung eine elektrische Spannung entstehen, deren Amplitude der Feldstärke des äußeren Magnetfeldes proportional ist und deren Frequenz in einer geradzahliger Harmonischen der Frequenz des erregenden Wechselfeldes besteht. Wenn auch die Oberwellenmagnetfeldsensoren in diesem Zusammenhang eine besondere Bedeutung einnehmen, so kommen für den Einsatz in Magnetfelddifferenzsonden, insbesondere den sogenannten Suchgeräten grundsätzlich auch andere Magnetfeldsensoren in Frage.

Häufig müssen die genannten Differenzsonden Magnetfelddifferenzen in der Größenordnung von 1 nT auflösen, während sie sich unter dem Einfluß einer Feldstärke von 50 000 nT befinden, z. B. unter dem Einfluß des magnetischen Erdfeldes bei den o. g. Suchgeräten. Das bedeutet jedoch, daß an die Parallelität der magnetischen Achsen der verwendeten Magnetfeldsensoren untereinander bzw. mit der gedachten Geraden sehr hohe Anforderungen gestellt werden müssen, wenn bei einer Drehung der Differenzsonde, z. B. um deren Lächsachse, nicht eine Magnetfelddifferenz vorgetäuscht werden soll. Bei den genannten Zahlenwerten müßte der Winkelfehler der Parallelität kleiner als 4 Winkelsekunden, also $2 \cdot 10^{-5}$ rad gehalten werden.

Die Empfindlichkeit der Differenzsonden bei der Durchführung von Suchaufgaben steigt naturgemäß mit größer werdendem Basisabstand der Magnetfeldsensoren an. Die obere Grenze für den Basisabstand wird bestimmt durch Temperatur- und Alterungseffekte, die eine Dejustierung der Parallelität der magnetischen Achsen der Magnetfeldsensoren bewirken. Sie liegt bisher bei etwa 0,5 m.

Eine Magnetfelddifferenzsonde, die der eingangs definierten Gattung weitgehend entspricht, ist aus DE-PS 2 408 547 bekannt. Bei der dort beschriebenen Differenzsonde ist jeweils ein die Ausrichtung der magnetischen Achse eines Magnetfeldsensors bestimmendes Magnetkernelement an zwei mit einem gewissen Abstand parallel zueinander verlaufenden, gespannten Drahtstück befestigt. An einem Ende der Drahtstücke sind Parallelisierungseinrichtungen angebracht, die eine genaue Justierung der Parallelität der Magnetkernelemente in zwei zueinander senkrechten Ebenen ermöglichen. Die beiden Drahtstücke sind im allgemeinen Teile eines zusammenhängenden Drahtes, der durch eine Umlenkeinrichtung zu einer U-förmigen Schleife geformt wird und der durch eine an der Umlenkeinrichtung angreifende Federanordnung unter mechanischer Spannung gehalten wird.

Gegenüber früheren Differenzsonden hat die beschriebene einen wesentlichen Vorteil aufzuweisen. Während bei den früheren Differenzsonden, deren Magnetfeldsensoren am oberen bzw. unteren Ende eines Sondenrohres in das letztere eingebaut waren, jede Verbiegung des Sondenrohres eine fühlbare Dejustierung der Parallelität der magnetischen Achsen bewirkte, ist bei den beschriebenen Differenzsonden diese Fehlerquelle beseitigt. Es verbleiben jedoch andere schädliche Einflußmöglichkeiten auf die Parallelität, die zwar nicht ganz so gravierend, aber dennoch nicht ohne Bedeutung sind. Unterschiedliche Ausdehnung des Materials der Umlenkeinrichtung und des Materials zwischen den Einspannstellen der freien Enden der U-förmig gebogenen Drahtschleife bewirkt eine Dejustierung der Parallelität. Das gleiche gilt in verstärktem Maße für eine Verdrehung der Umlenkeinrichtung um die Längsachse der Differenzsonde. Eine solche Verdrehung um einen bestimmten Winkel bewirkt an den beiden in die Umlenkeinrichtung einlaufenden Enden der Drahtstücke entgegengesetzt gerichtete Ortsverlagerungen und damit einen Parallelitätsfehler, der um so größer ist, je größer der Durchmesser der Umlenkeinrichtung gewählt wurde. Vermeiden kann man diesen Fehler nur durch eine entsprechend stabile und gewichtige Kontruktion der Umlenkeinrichtung, was zwangsläufig zu erschwerter Handhabung und erhöhtem Aufwand führt. Die notwendigerweise für einen relativ großen Einstellbereich dimensionierten Parallelisierungseinrichtungen bilden eine weitere Möglichkeit für Änderungen des Parallelitätszustandes aufgrund von Temperatur- und Stoßbeanspruchung. Zudem erfordern die beiden Parallelisierungseinrichtungen feinfühlig verstellbare Schlitten mit sorgfältig bearbeiteten Führungsflächen, was einen erheblichen Aufwand bedingt. Soll der Parallelitätsfehler klein gehalten werden, den die Schwerkraft durch den Durchhang der beiden Drahtstücke bei Horizontallage der Differenzsonde verursacht, so muß mit möglichst hoher Spannkraft gearbeitet werden. Das bedeutet jedoch, daß man für guten Ausgleich der Zugspannung in den beiden Drahtstücken sorgen muß, indem man die Umlenkeinrichtung als leichtgängige Umlenkrolle ausführt. Für die schlagfreie Lagerung der letzteren muß dann jedoch ein hoher Aufwand getrieben werden. Der Wunsch nach einem geringen Durchhang der Drahtstücke führt zu Werkstoffen für die letzteren, die leicht sind und bei geringer Dehnung eine große Bruchlast aufweisen. Solche Werkstoffe verlangen jedoch aufgrund ihrer Sprödigkeit einen weiten Krümmungsradius, was zu unerwünscht hohen Durchmessern der Umlenkeinrichtung führt.

Aus DE-AS 1 153 451 ist eine Magnetfelddifferenzsonde bekannt, die keine Umlenkeinrichtung benötigt. Die Magnetkerne dieser Differenzsonde sind in Glas oder Quarzstäbe eingebaut, die mit ihren äußeren Enden an den Abschlußflächen eines Metallrohres befestigt sind und deren innere, einander zugekehrte Enden miteinander durch eine Feder verbunden sind. Die letztere soll die Stäbe unter mechanische Spannung setzen und so die Magnetkerne miteinander zum Fluchten bringen. Gelänge dies, so könnten Einrichtungen zum Justieren der Parallelität weitgehend entbehrlich werden. Bei der beschriebenen Anordnung stellt sich jedoch das gewünschte Ziel, das Fluchten der beiden Magnetkerne, nur dann ein, wenn es gelingt, bei jedem der beiden Stäbe die Verbindungslinien zwischen den beiden Befestigungspunkten an den Enden der Stäbe fluchtend oder wenigstens parallel zur Längsachse der Magnetkerne zu machen. Das ist bei den vorliegenden Glas- bzw. Quarzstäben kaum möglich oder jedenfalls nur mit großem Aufwand zu erreichen.

Aufgabe der vorliegenden Erfindung ist es, eine Differenzsonde der eingangs beschriebenen Art zu schaffen, deren Parallelität von der Herstellung her so gut ist, daß eine Justierung der Parallelität entweder ganz entfallen kann oder nur in sehr geringem Umfang notwendig ist, deren Parallelität ferner auch bei größeren Basisabständen als bisher üblich den Beanspruchungen durch Stoß und Temperatur gut standhält.

Die Aufgabe wird gelöst durch eine Differenzsonde, die gemäß Patentanspruch 1 gekennzeichnet ist. Vorteilhafte Ausgestaltungen der Erfindung sind in den Unteransprüchen angegeben.

Bei der erfindungsgemäßen Differenzsonde sind die die magnetischen Achsen der Magnetfeldsensoren bestimmenden Magnetkernelemente auf einer einheitlichen, zwischen zwei Endpunkten eingespannten Drahtanordnung angebracht, die zwischen den Magnetkernelementen weder durch eine Umlenkeinrichtung noch auf andere Weise gestützt ist. Infolgedessen hängt bei hinreichender Spannung der Drahtanordnung der Parallelitätsfehler der Magnetkernelemente nur noch von zwei Faktoren ab, nämlich vom Durchhang der Drahtanordnung aufgrund der Schwerkraft und von der Parallelitätsabweichung der Magnetkernelemente gegenüber der Achse der Drahtanordnung am Ort der Anbringung der Magnetkernelemente. Durch optimale Auswahl des Drahtwerkstoffes läßt sich der auf dem Durchhang beruhende Parallelitätsfehler zumindest dann recht klein halten, wenn nur die Magnetkernelemente, nicht auch die übrigen Teile der Magnetfeldsensoren von der Drahtanordnung getragen werden. In der bei Suchgeräten normalerweise üblichen im wesentlichen vertikalen Lage der Differenzsonde spielt der vom Durchhang verursachte Fehler von vornherein eine kleinere Rolle. Die Anbringung der Magnetkernelemente an der Drahtanordnung läßt sich, wie im folgenden noch gezeigt wird, so vorteilhaft gestalten, daß in vielen Fällen auf eine Justierung ganz verzichtet werden kann. In allen Fällen wird jedoch der für die Justierung der Parallelität erforderliche Bereich außerordentlich verringert, so daß Parallelisierungsverfahren einsetzbar werden, die für größere Bereiche ungeeignet sind, z. B. das sogenannte magnetische Parallelisierungsverfahren, das eine berührungslose vollständige Kompensation der verbliebenen geringfügigen Parallelitätsmängel ermöglicht.

Nach dem genannten Verfahren wird ein senkrecht zum Magnetkernelement ausgerichtetes Abgleichelement, ein Streifen oder Stift aus hochpermeablem weichmagnetischem Werkstoff, in die Nähe des Magnetkernelements gebracht, dessen magnetische Achse auf diese Weise in Richtung des Abgleichelements gekippt wird. Das Verfahren ist an sich seit langem bekannt, z. B. aus US-PS 3 487 459, derzufolge ferromagnetische Schraubkerne benutzt werden, um in der besagten Weise den Parallelitätsabgleich durchzuführen. Es ist jedoch in der Praxis noch nicht gelungen, die mechanische Parallelisierung durch die magnetische Parallelisierung zu ersetzen. Sobald nämlich die bisher erforderlichen relativ starken Beeinflussungen der magnetischen Achsen erreicht werden sollten, stellten sich unerwünschte Nebenwirkungen ein. Da für Differenzsonden exakte Übereinstimmung der Eigenschaften der einzelnen Sensoren gefordert werden muß, störte neben einer wachsenden Nichtlinearität des betroffenen Sensors mit zunehmendem Kippen der magnetischen Achse auch direkt die Änderung der Empfindlichkeit eines Sensors in Abhängigkeit von der Annäherung der als Abgleichelement benutzten Streifens oder Stiftes an das Magnetkernelement. Außerdem bestand bei den erforderlichen relativ großen magnetischen Abgleichelementen, die im übrigen einer feinfühligen Verstellung bedurften, die Gefahr, daß unter dem Einfluß starker Magnetfelder sich Störungen durch magnetische Remanenz einstellten. Wegen der Kleinheit der im Falle der erfindungsgemäßen Differenzsonde noch zu behebenden Parallelitätsfehler genügen hier zur Herstellung der Parallelität winzige Abgleichelemente oder entsprechend große Abstände vom Magnetkernelement. Die oben genannten unerwünschten Nebenwirkungen lassen sich daher mit Sicherheit ausschließen, so daß bei der erfindungsgemäßen Differenzsonde erforderlichenfalls an die Stelle der mechanischen Parallelisierung vorbehaltlos die magnetische Parallelisierung treten kann.

Zusammenfassend darf man sagen, daß die erfindungsgemäße Differenzsonde gegenüber früheren eine starke Vereinfachung der Konstruktion, eine wesentliche Herabsetzung des Herstellungsaufwandes, insbesondere eine außerordentliche Stabilität der Parallelität und den Wegfall von Wartungsaufwand erwirkt. Ferner wird durch die Erfindung der Bau einer Differenzsonde möglich, die bei einem Basisabstand von 2 m sehr gute Eigenschaften aufweist.

Im folgenden wird die Erfindung an Hand von Ausführungsbeispielen und mit Hilfe von Figuren näher erläutert. Es zeigt im einzelnen

Fig. 1 eine erfindungsgemäße Differenzsonde,
Fig. 2 die Umgebung einer Drahtanordnung,
Fig. 3 ein Gewinderohr,
Fig. 4 ein Magnetkernelement,
Fig. 5 ein Abgleichelement.

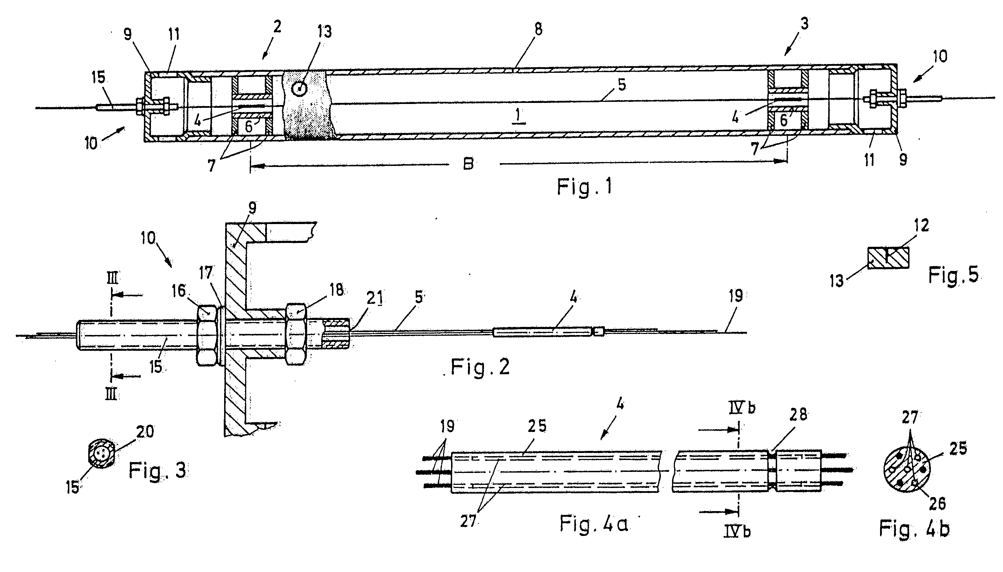

Die in Fig. 1 dargestellte Differenzsonde 1 besitzt zwei Oberwellenmagnetfeldsensoren 2 und 3, die in den Fachleuten geläufiger Weise zusammengeschaltet sind und am Ausgang einer hier nicht abgebildeten Auswerteeinrichtung ein Signal bewirken, das der auf den Basisabstand B zwischen den beiden Sensoren 2 und 3 bezogenen Magnetfelddifferenz entspricht. Einen wesentlichen Bestandteil der beiden genau gleich aufgebauten Sensoren 2 und 3 bilden die die magnetischen Achsen der beiden Sensoren bestimmenden Magnetkernelemente 4. Sie sind in weiter unten noch näher beschriebener Weise an einer Drahtanordnung 5 derart befestigt, daß ihre Ausrichtung sehr genau mit der der Drahtanordnung 5 übereinstimmt. Spulensätze 6 dienen dazu, einerseits magnetische Wechselfelder aufzubauen, die die Magnetkernelemente 4 bis in die Sättigung magnetisieren, andererseits eine der magnetischen Feldstärke entsprechende Signalspannung zu empfangen. Mittels Stützringen 7 sind die Spulensätze 6 an der Innenwand eines Sondenrohres 8 befestigt, das seinerseits in ein nicht abgebildetes Tragrohr eingebaut sein kann. Anstelle der hier dargestellten Sensoranordnung kann ebensogut jeder der beiden Sensoren 2 und 3 aus je einem Paar von Spulensätzen 6 und Magnetkernelementen 4 bestehen. In diesem Falle sind die beiden zu einem Sensor gehörigen Spulensätze und Kernelemente einander in Längsrichtung der Differenzsonde benachbart angeordnet, und beide Kernelemente sind hintereinander an der Drahtanordnung 5 befestigt.

Das Sondenrohr 8 wird an beiden Seiten abgeschlossen durch Kappen 9, an denen einfache Vorrichtungen 10 zum Strecken der Drahtanordnung 5 angebracht sind. Vorrichtung 10 ist in Fig. 2 noch einmal, in gegenüber Fig. 1 vergrößertem Maßstab abgebildet. Sie setzt sich zusammen aus einem Gewinderohr 15, einer Spannmutter 16, einer Unterlagscheibe 17 und einer Kontermutter 18. Öffnungen 11 im Mantel der Kappe 9 ermöglichen den Zugriff zur Kontermutter 18 bei aufgesetzter Kappe 9. In die Bohrung des Gewinderohres 15 ist die aus drei parallel laufenden einzelnen Drähte 19 bestehende Drahtanordnung 5 eingeklebt. Gewinderohr 15 kann an zwei Seiten Abplattungen 20 besitzen, die am besten im Schnitt nach Fig. 3 zu erkennen sind. Sie dienen dazu, während des Streckens der Drahtanordnung 5 beim Anziehen der Spannmutter 16 das Gewinderohr 15 am Verdrehen zu hindern, indem es entweder einfach mit einem Schraubenschlüssel festgehalten oder in der Bohrung der Kappe 9 verdrehsicher geführt wird. An den Werkstoff der Drahtanordnung 5 werden hohe Anforderungen gestellt. Er soll eine geringe Dichte aufweisen, damit einerseits der Durchhang aufgrund der Schwerkraft in Grenzen bleibt, andererseits bei Stößen möglichst geringe Kräfte auftreten und die dabei angeregten Schwingungen schnell abklingen. Die Zugfestigkeit soll groß sein, damit auch bei hinreichend großem Sicherheitsabstand von der Zugfestigkeit eine gute Straffung der Drahtanordnung 5 möglich ist. Selbstverständlich kommt nur ein amagnetischer Werkstoff in Betracht. Gute Ergebnisse stellten sich zum einen mit einem Wolframdraht ein, zum anderen mit einer Borfaser, deren Herstellung durch Niederschlag von elementarem Bor auf einen Wolframdraht von 10 μm Stärke erfolgt. Dabei wird die Schwierigere Verarbeitbarkeit der spröden Borfasern weitgehend aufgewogen durch ihre etwa zehnmal geringere Dichte bei größenordnungsmäßig gleicher Zugfestigkeit.

Die Ausführung der Drahtanordnung 5 mit mehreren Drähten 19 hat verschiedene Vorteile. Bei gegebener Länge des für die Klebung vorgesehenen Bereichs und bei gegebenem Querschnitt der Drahtanordnung 5 ist die für die Klebkraft wirksame Oberfläche größer, wenn der gewünschte Querschnitt durch mehrere Drähte realisiert wird. Auch ist die Biegsamkeit einer Mehrzahl von Drähten höher als die eines Einzeldrahtes, dessen Querschnitt dem Gesamtquerschnitt der Drähte entspricht. Weitere Vorteile bringt die Drahtanordnung 5 im Zusammenhang mit der im vorliegenden Beispiel gewählten Ausführung der Magnetkernelemente 4 nach der Lehre von DE-PS 2 518 764.

In Fig. 4 ist ein solches Magnetkernelement 4 im gegenüber Fig. 2 etwa zahnfach vergrößerten Maßstab herausgezeichnet. Ein Kapillarröhrchen 25, vorzugsweise aus keramischem Material, besitzt sieben symmetrisch angeordnete Kapillaren 26, von denen vier mit hochwertigem drahtförmigem Magnetkernmaterial 27 bestückt sind. Durch die übrigen drei Kapillaren sind die Drähte 19 der Drahtanordnung 5 gezogen. Die Orte dieser drei, wie auch die der vorgenannten vier der Kapillaren 26 sollen vorzugsweise symmetrisch zur Mitte des Kapillarröhrchens 25 angeordnet sein, damit torsionale Kräfte sich herausheben und der magnetische Schwerpunkt in die Mitte der Drahtanordnung 5 zu liegen kommt. Die gute gegenseitige Parallelität der Kapillaren kann um so vollständiger ausgenutzt werden, je besser sowohl das Magnetkernmaterial 27 als auch die Drähte 19 in die Kapillaren 26 passen. Darüber hinaus liegen die Drähte 19 an der Wand der Kapillaren 26 gut an, wenn sie an der Klebestelle 21 ein wenig weiter oder enger beabstandet sind, als dem Abstand der Kapillaren 26 entspricht. Aus der Parallelführung mehrerer Drähte 19 resultiert neben der Verhinderung ungewollter Torsion noch eine Verringerung des Durchhanges. Um mechanische Spannungen zwischen Kapillarröhrchen 25 und den Drähten 19 zu vermeiden, sind die letzteren mit dem Kapillarröhrchen 25 nur einseitig durch eine Klebestelle verbunden. Hierzu kann eine um das Kapillarröhrchen 25 herum geführte Nut 28 vorgesehen sein, die es erlaubt, den Klebstoff von außen anzubringen.

Beim Zusammenbau der beschriebenen Differenzsonde 1 kann man etwa in folgender Weise vorgehen. Man fädelt in die vorbereiteten Magnetkernelemente 4 sowie in zwei Gewinderohre 15 die drei Drähte 19 der Drahtanordnung 5 ein und läßt diese etwas über die auf richtigen Abstand gebrachten Gewinderohre 15 hinausstehen. Die freien Enden der Drahtanordnung 5 werden in eine einfache Spannvorrichtung eingespannt. Bei leichter Spannung der Drahtanordnung 5 füllt man die Gewinderohre 15 mit Gießharz an. Um die Drähte 19 an der Klebestelle in die gewünschte Lage und auf passenden Abstand zu bringen, schiebt man vorübergehend die Magnetkernelemente 4 in die Nähe der Klebestellen 21. Nach dem Aushärten der letzteren bewegt man die Magnetkernelemente 4 an ihren vorgesehenen Platz und befestigt sie hier durch Anbringen des Klebstoffes in der Nut 28. Der so entstandene Strang, bestehend aus Drahtanordnung 5, Magnetkernelement 4 und den noch mit Kontermuttern 18 versehenen Gewinderohren 15, wird in das Sondenrohr 8 eingeführt. Nach Einbau der Kappen 9 wird die Drahtanordnung 5 mit Hilfe einer der beiden Spannmuttern 16 gestreckt bis die vorgesehene Spannung erreicht ist. Anschließend können durch Anziehen der Kontermuttern 18 die Gewinderohre 15 abgesichert werden.

Die Parallelität der Magnetkernelemente 4 kann leicht geprüft werden, indem man das vertikal aufgehängte Sondenrohr 8 um seine Achse dreht und feststellt, welche Anzeige dabei erfolgt. In vielen Fällen wird die erzielte Parallelität bereits ausreichend sein. Ist dies noch nicht der Fall, so kann man die Parallelität häufig in einfacher Weise verbessern. Man verdreht zu diesem Zweck die beiden Magnetkernelemente 4 axial gegeneinander und bringt dabei die leichten Schräglagen von deren magnetischen Achsen, die aus den jeweiligen Schräglagen der einzelnen Magnetkernmaterialdrähte 27 resultieren, zur Deckung. Das geschieht, indem man eines der beiden Gewinderohre 15 so weit um seine Achse dreht, bis die Anzeigeänderung bei einer Axialdrehung der Differenzsonde 1 ein Minimum wird. Um dies zu ermöglichen, ist die Bohrung einer der beiden Kappen 9 so ausgeführt, daß sie eine Verdrehung des Gewinderohres 15 zuläßt.

Für die praktische Durchführung der magnetischen Parallelisierung bieten sich verschiedene Möglichkeiten an. So kann man z. B. die erforderlichen winzigen Abgleichstreifen direkt an die Stirnseite eines Stützringes 7 ankleben. Der Betrag des zu behebenden Parallelitätsfehlers, d. h. die maximale Anzeigedifferenz bei einer Axialdrehung der Differenzsonde 1, bestimmt den radialen Abstand des Abgleichstreifens von der Rohrmitte, während die resultierende Richtung des Parallelitätsfehlers für die Winkellage des Abgleichstreifens maßgebend ist. Eine andere Möglichkeit für die Durchführung der magnetischen Parallelisierung besteht darin, nach Fig. 5 die Abgleichstreifen 12 in kleine, aus Kunststoff hergestellte Pillen 13 anzulagern, die auf die Außenseite des Sondenrohres 8 aufgeklebt werden können. Um unterschiedlichen Beträgen des Parallelitätsfehlers zu entsprechen, wird hier statt des radialen Abstandes der axiale Abstand variiert.

## Patentansprüche

1. Magnetfelddifferenzsonde mit zwei Magnetfeldsensoren, die parallel zu einer gedachten Geraden ausgerichtete magnetische Achsen und die Ausrichtung dieser magnetischen Achsen bestimmende Magnetkernelemente besitzen, die von einander einen bestimmten Basisabstand entlang der gedachten Geraden aufweisen, die an eine elektronische Auswerteeinrichtung angeschlossen sind und die am Ausgang der letzteren ein elektrisches Signal entstehen lassen, das gemäß dem gegebenen Basisabstand der Differenz der an den Orten der beiden Magnetfeldsensoren vorhandenen Magnetfelder entspricht, wobei die Ausrichtung der magnetischen Achsen parallel zur gedachten Gerade erzielt wird, indem die Magnetfeldsensoren oder zumindest ihre Magnetkernelemente an einer parallel zur gedachten Geraden verlaufenden, gespannten, amagnetischen Anordnung befestigt sind, die zwischen den die Ausrichtung der magnetischen Achsen bestimmenden Magnetkernelementen nicht gestützt ist, dadurch gekennzeichnet, daß die Anordnung (5) aus einem Draht oder mehreren in einem gewissen seitlichen Abstand parallel zueinander laufenden Drähten (19) besteht, daß jedes Magnetkernelement (4) einen länglichen Körper (25) aus amagnetischem Material besitzt, der eine Anzahl exakt parallel verlaufender Öffnungen (26) aufweist, von denen eine oder mehrere drahtförmige Magnetkerne (27) enthalten, von denen ferner eine oder mehrere von einem bzw. mehreren Drähten (19) der Anordnung (5) durchlaufen werden.

2. Magnetfelddifferenzsonde nach Anspruch 1, dadurch gekennzeichnet, daß die für die Lagerung der Magnetkerne (27) benutzten Öffnungen (26) sowie die für die Durchführung der Drähte (19) benutzten Öffnungen (26) symmetrisch zur Mitte des Körpers (25) angeordnet sind.

3. Magnetfelddifferenzsonde nach Anspruch 1 oder 2, dadurch gekennzeichnet, daß sowohl die Drähte (19) als auch die Magnetkerne (27) möglichst exakt in die Öffnungen (26) passen.

4. Magnetfelddifferenzsonde nach Anspruch 1 oder 2, dadurch gekennzeichnet, daß die gegenseitigen seitlichen Abstände der Drähte (19) an den Einspannstellen größer oder kleiner sind als die Abstände der die Drähte (19) aufnehmenden Öffnungen (26) der Körper (25).

5. Magnetfelddifferenzsonde nach einem der vorhergehenden Ansprüche, dadurch gekennzeichnet, daß der Körper (25) zylindrisch ist und an einem Ende eine ringförmige Nut (28) besitzt, die das Verkleben wenigstens eines Teils der Drähte (19) oder Magnetkerne (27) von außen her erlaubt.

6. Magnetfelddifferenzsonde nach einem der vorhergehenden Ansprüche, dadurch gekennzeichnet, daß zur Verbesserung der Parallelität der Magnetkernelemente (4) diese um ihre Achse gegeneinander verdrehbar sind.

7. Magnetfelddifferenzsonde nach einem der vorhergehenden Ansprüche, dadurch gekennzeichnet, daß in der Nähe von einem der Magnetkernelemente (4) ein sehr kleiner, länglicher Abgleichkörper (12) aus hochpermeablem, weichmagnetischem Werkstoff, z. B. ein Streifen oder Stift, in etwa senkrechter Ausrichtung zum Magnetkernelement (4) angeordnet ist.

8. Magnetfelddifferenzsonde nach einem der vorhergehenden Ansprüche, dadurch gekennzeichnet, daß der Draht/die Drähte (19) der Anordnung (5) an einem Ende oder beiden Enden in einer Hülse (15) befestigt ist, die sich mittels Gewinde in axialer Richtung verstellen läßt.

9. Magnetfelddifferenzsonde nach Anspruch 9, dadurch gekennzeichnet, daß die Hülse/n (15) verdrehsicher geführt sind.

10. Magnetfelddifferenzsonde nach einem der vorhergehenden Ansprüche, dadurch gekennzeichnet, daß die mechanische Spannung der Anordnung (5) ohne Benutzung zusätzlicher Federkraft nur auf ihrer elastischen Dehnung beruht.

11. Magnetfelddifferenzsonde nach einem der vorhergehenden Ansprüche, dadurch gekennzeichnet, daß der Basisabstand B größer als 1 m ist.

**Claims**

1. A magnetic-field differential probe with two magnetic-field sensors having magnetic axes aligned parallel to an imaginary straight line and magnetic-core elements defining the alignment of these magnetic axes, the magnetic-field sensors being spaced a specified distance along the imaginary straight line and connected to an electronic evaluating circuit producing at the output of the latter an electrical signal which, according to the spacing of the field sensors, corresponds to the difference between the magnetic fields at the locus of the two magnetic-field sensors, alignment of the magnetic axes parallel to the imaginary straight line being obtaines by attaching the magnetic-fields sensors, or at least their magnetic-core elements, to a taut non-magnetic mechanism lying parallel to the imaginary straight line and being unsupported between the magnetic-core elements defining the alignment of the magnetic axes; characterized by the mechanism (5) comprising a single wire or several parallel wires (19) a certain distance apart; each magnetic-core element (4) having an elongated body (25) of non-magnetic material with a number of exactly parallel apertures (26) of which one or more contain wire-like magnetic cores (27) and ohne or more being penetrated by one or more wires (19) of the mechanism (5).

2. A magnetic-field differential probe as claimed in Claim 1; characterized by the apertures (26) used for supporting the magnetic cores (27) and the apertures (26) containing the wires (19) being arranged symmetrically about the centre of the body (25).

3. A magnetic-field differential probe as claimed in Claim 1 or 2; characterized by both the wires (19) and the magnetic cores (27) fitting as accurately as possible in the apertures (26).

4. A magnetic-field differential probe as claimed in Claim 1 or 2; characterized by the transverse spacing of the wires (19) at the points of attachment being greater or less than the spacing of the apertures (26) in the body (25) containing the wires (19).

5. A magnetic-field differential probe as claimed in any of the previous claims; characterized by the body (25) being cylindrical and having at one end a circular groove (28) enabling at least some of the wires (19) or magnetic cores (27) to be cemented from the outside.

6. A magnetic-field differential probe as claimed in any of the previous claims; characterized by the magnetic-core elements (4) being independently rotatable about their axes on order to improve the parallelism.

7. A magnetic-field differential probe as claimed in any of the previous claims; characterized by a very small, elongated balancing element (12) of high-permeability, magnetically-soft material, e. g. a strip or pin, being placed close and approximately perpendicular to one of the magnetic-core elements (4).

8. A magnetic-field differential probe as claimed in any of the previous claims; characterized by the wire or wires (19) of the mechanism (5) being secured at one or both ends in a sleeve (15) which can be adjusted in the axial direction by means of a thread.

9. A magnetic-field differential probe as claimed in Claim 8; characterized by the sleeve or sleeves (15) being secured to prevent rotation.

10. A magnetic-field differential probe as claimed in any of the previous claims; characterized by the mechanical tension of the mechanism (5) being based on its elastic strain only without the use of additional spring force.

11. A magnetic-field differential probe as claimed in any of the previous claims; characterized by the spacing distance B being greater than 1 metre.

## Revendications

1. Sonde différentielle de champs magnétiques à deux détecteurs de champs magnétiques qui possèdent des axes magnétiques orientés parallèlement par rapport à une ligne droite imaginaire et des éléments à noyau magnétique déterminant l'orientation de ces axes magnétiques. Ces détecteurs présentent entre eux une distance de base donnée le long de la ligne droite imaginaire. Ils sont reliés à un dispositif d'évaluation électronique et engendrent à la sortie de ce dernier un signal électrique qui, conformément à la distance de base donnée, correspond à la différence des champs magnétiques présents à l'emplacement des deux détecteurs de schamps magnétiques, l'orientation des axes magnétiques parallèle à la ligne droite imaginaire étant obtenue de facon que les détecteurs de champs magnétiques ou du moins leurs éléments à noyau magnétique soient fixés à un système tendu, amagnétique et parallèle à la ligne droite imaginaire, système qui ne possède aucun appui entre les éléments à noyau magnétique déterminant l'orientation des axes magnétiques, caractérisée par le fait que le système (5) se compose de un ou plusieurs fils parallèles et séparés par une certaine distance (19), chaque élément à noyau magnétique (4) possède un corps ablong (25) fait d'une matière amagnétique, lequel présente un certain nombre d'orifices d'un parallélisme précis (26) dont un ou plusieurs contiennent des noyaux magnétiques filiformes (27) et dont par ailleurs un ou plusieurs sont traversés par un ou plusieurs fils (19) du système (5).

2. Sonde différentielle de champs magnétiques, suivant revendication 1, caractérisée par le fait que les orifices (26) utilisés pour le logement des noyaux magnétiques (27) ainsi que les orifoces utilisés pour le passage des fils (19) sont disposés symétriquement par rapport à l'axe du corps (25).

3. Sonde différentielle de champs magnétiques, suivant revendication 1 ou 2, caractérisée par le fait que tant les fils (19) que les noyaux magnétiques (27) doivent s'adapter aussi exactement que possible aux orifices (26).

4. Sonde différentielle de champs magnétiques, suivant revendication 1 ou 2, caractérisée par le fait que les distances entre les fils (19) sont supérieures ou inférieures, aux points de fixation, aux distances entre les orifices (26) des corps (25) recevant les fils (19).

5. Sonde différentielle de champs magnétiques, suivant l'une des revendications précédentes, caractérisée par le fait que le corps (25) est cylindrique et possède à une extrémité une encoche annulaire (28) qui permet le collage d'au moins une partie des fils (19) ou des noyaux magnétiques (27) depuis l'extérieur.

6. Sonde différentielle de champs magnétiques, suivant l'une des revendications précédentes, caractérisée par le fait que, pour l'amélioration du parallélisme des éléments à noyau magnétique (4), ceux-ci peuvent être tournés l'un vers l'autre autour de leur axe.

7. Sonde différentielle de champs magnétiques, suivant l'une des revendications précédentes, caractérisée par le fait que, à proximité de l'un des éléments à noyau magnétique (4), un très petit élément d'équilibrage oblong (12) fait d'une matière hautement perméable et magnétique douce, par ex. une bande ou une tige, est disposé à peu près perpendiculairement à l'élément à noyau magnétique (4).

8. Sonde différentielle de champs magnétiques, suivant l'une des revendications précédentes, caractérisée par le fait que le fil/les fils (19) du système (5) est fixé à une extrémité ou à deux extrémités à une douille (15) qui se règle dans le sens axial grâce à un filetage.

9. Sonde différentielle de champs magnétiques, suivant la revendication 8, caractérisée par le fait que la (les) douille(s) (15) possède(nt) un quidage résistant à la torsion.

10. Sonde différentielle de champs magnétiques, suivant l'une des revendications précédentes, caractérisée par le fait que la tension mécanique du système (5) repose sur son allongement élastique, sans utilasation d'une force élastique supplémentaire.

11. Sonde différentielle de champs magnétiques, suivant l'une des revendications précédentes, caractérisée par le fait que la distance de base est supérieure à 1 m.

Fig. 1

Fig. 2

Fig. 3

Fig. 4a

Fig. 4b

Fig. 5

0 028 302